Europäisches Patentamt

European Patent Office

Office européen des brevets

(19)

(11) EP 0 753 158 B1

(12) EUROPÄISCHE PATENTSCHRIFT

(45) Veröffentlichungstag und Bekanntmachung des Hinweises auf die Patenterteilung:
27.05.1998 Patentblatt 1998/22

(21) Anmeldenummer: 95913867.8

(22) Anmeldetag: 28.03.1995

(51) Int Cl.6: **G01R 33/561**

(86) Internationale Anmeldenummer:
PCT/DE95/00418

(87) Internationale Veröffentlichungsnummer:
WO 95/27218 (12.10.1995 Gazette 1995/43)

(54) **PULSSEQUENZ FÜR EIN KERNSPINTOMOGRAPHIEGERÄT**

PULSE SEQUENCE FOR AN ISOTOPIC SPIN TOMOGRAPHY APPARATUS

SEQUENCE D'IMPULSIONS POUR UN APPAREIL DE REMNOGRAPHIE

(84) Benannte Vertragsstaaten:
DE GB IT

(30) Priorität: 31.03.1994 DE 4411362
04.08.1994 DE 4427685

(43) Veröffentlichungstag der Anmeldung:
15.01.1997 Patentblatt 1997/03

(73) Patentinhaber: SIEMENS
AKTIENGESELLSCHAFT
80333 München (DE)

(72) Erfinder: HEID, Oliver
CH-3007 Bern (CH)

(56) Entgegenhaltungen:
EP-A- 0 560 168          WO-A-90/00743
WO-A-93/01509           WO-A-93/02618
US-A- 5 125 407

• JOURNAL OF MAGNETIC RESONANCE.,
Bd.101B, Nr.1, 1. Februar 1993, ORLANDO, MN
US Seiten 106 - 109 I.J. LOWE ET AL. 'DANTE
ULTRAFAST IMAGING SEQUENCE (DUFIS)'
• MAGMA, Bd.1, Nr.1, 1. März 1993, LONDON, UK
Seiten 39 - 48 J. HENNIG ET AL. 'BURST
IMAGING'
• MAGNETIC RESONANCE IN MEDICINE., Bd.29,
Nr.2, 1. Februar 1993, DULUTH,MN US Seiten 280
- 283 O. HEID ET AL. 'QUEST - A QUICK ECHO
SPLIT NMR IMAGING TECHNIQUE'
• MAGNETIC RESONANCE IN MEDICINE., Bd.33,
Nr.1, 1. Januar 1995, DULUTH,MN US Seiten 143
- 149 O. HEID ET AL. 'ULTRA-RAPID GRADIENT
ECHO IMAGING'

## Beschreibung

Die Erfindung betrifft eine Pulssequenz für ein Kernspintomographiegerät nach dem Oberbegriff des Anspruches 1. Eine derartige Pulssequenz ist bekannt aus Journal of Magnetic Resonance, Series B 101 (1993), Februar, Nr. 1, Seiten 106 bis 109.

Bei der MR-Bildgebung sind kurze Bildaufnahmezeiten von besonderer Bedeutung. Dies gilt nicht nur in Hinblick auf einen möglichst hohen Patientendurchsatz, sondern zum Beispiel auch zur Vermeidung von Bewegungs-Artefakten. Für bestimmte Aufnahmetechniken, z.B. cine-mode (Aufnahme bewegter Bilder), sind kurze Bildaufnahmezeiten unumgänglich.

Besondere Bedeutung haben schnelle Pulssequenzen z.B. für die Bestimmung der Ausbreitung von Kontrastmitteln, für die Beobachtung der Herzbewegung, für die Gehirnfunktion und für die Kinematik von Gelenken, da mehrere Bilder in schneller Folge aufgenommen werden müssen.

Von den bisher bekannten Methoden können mit dem EPI-Verfahren die kürzesten Bildaufnahmezeiten (40 bis 100 ms) erzielt werden. Das EPI-Verfahren ist beispielsweise in der europäischen Patentschrift 0 076 054 beschrieben.

Dabei wird zu Beginn der Pulssequenz ein HF-Anregungspuls unter einer Wirkung eines Schichtselektionsgradienten in einer ersten Richtung auf ein Untersuchungsobjekt eingestrahlt. Damit werden Kernspins in einer Schicht des Untersuchungsobjekts angeregt. Nach der Anregung wird ein Phasencodiergradient in einer zweiten Richtung und ein Auslesegradient in einer dritten Richtung eingeschaltet. Erste, zweite und dritte Richtung stehen senkrecht aufeinander. Der Auslesegradient besteht aus einem Vorphasierpuls sowie aus Teilpulsen wechselnder Polarität. Durch diese wechselnde Polarität des Auslesegradienten werden die Kernspins im Wechsel dephasiert und wieder rephasiert, so daß eine Folge von Kernspinresonanzsignalen entsteht. Dabei werden nach einer einzigen Anregung so viele Signale gewonnen, daß der gesamte k-Raum abgetastet wird, d.h. daß die vorliegenden Informationen zur Rekonstruktion eines vollständigen Schnittbildes ausreichen.

Bei jedem Wechsel der Polarität des Auslesegradienten wird der Phasencodiergradient kurzzeitig eingeschaltet. Damit wird jedesmal die Phasenlage der Kernspins um eine Stufe weitergeschaltet. Die entstehenden Kernspinresonanzsignale werden im Zeitbereich abgetastet, digitalisiert und die so gewonnenen numerischen Werte in eine Rohdatenmatrix eingetragen. Aus dieser Rohdatenmatrix wird dann aufgrund einer zweidimensionalen Fourier-Transformation ein Bild des Untersuchungsobjektes rekonstruiert. Der Geschwindigkeitsvorteil des EPI-Verfahrens beruht im wesentlichen darauf, daß nach einer einzigen Anregung eine Vielzahl von Signalen gewonnen wird, die zur Rekonstruktion eines vollständigen Schnittbildes ausreichen. Sämtliche Signale, die letztlich Gradientenechos darstellen, müssen innerhalb des T2*-Zerfalls gewonnen werden. Daher muß der Auslesegradient sehr schnell bipolar geschaltet werden, so daß an die Anlage erhebliche technologische Anforderungen gestellt werden.

Ferner haben Gradientenechos, wie sie auch beim EPI-Verfahren erzeugt werden, gegenüber Spinechos den Nachteil, daß sie gegen lokale Feldinhomogenitäten empfindlich sind.

Aus der US-PS 4,818,940 ist eine Pulssequenz bekannt, bei der nach einem 90°-Hochfrequenzpuls durch mehrere aufeinanderfolgende 180°-Hochfrequenzpulse mehrere Spinechos gewonnen werden. Bei diesem Verfahren sind jedoch die Aufnahmezeiten länger als beim EPI-Verfahren und bei schneller Repetition wird bald die zulässige Hochfrequenzbelastung des Patienten erreicht.

Aus der WO 93/01509 ist eine als "GRASE" bezeichnete Pulssequenz bekannt, bei der ebenfalls nach einem 90°-Hochfrequenzpuls mehrere 180°-Hochfrequenzpulse folgen. Nach jedem 180°-Hochfrequenzpuls wird jedoch ein Auslesegradient mehrfach invertiert, so daß man je 180°-Hochfrequenzpuls mehrere Kernresonanzsignale erhält. Damit erhält man jeweils ein Segment des k-Raumes. Die Einsortierung der Kernresonanzsignale im k-Raum erfolgt so, daß von Zeile zu Zeile möglichst geringe Amplitudensprünge entstehen.

Aus der US-Patentschrift 5,126,673 ist eine Pulssequenz bekannt, bei der zur Anregung einer Probe eine Folge von vielen äquidistanten Hochfrequenzpulsen, ein sogenannter Puls-burst eingestrahlt wird. Die Hochfrequenzpulse weisen einen äußerst kleinen Flipwinkel in der Größenordnung von 0,1° bis 2° auf. Im Anschluß an die Folge der Hochfrequenzpuls wird ein Zug von äquidistanten Echosignalen mit möglichst konstanter Amplitude erhalten. Um die Amplitude der Echosignale möglichst konstant zu halten, werden Amplitude und Phase der Hochfrequenzpulse beeinflußt. Für die Bildgebung sind eine selektive Anregung bzw. Refokussierung sowie Auslese- und Phasencodiergradienten vorgesehen.

Ferner ist die Möglichkeit erwähnt, aus der äquidistanten Folge von Hochfrequenzpulsen eine mehr oder minder große Anzahl von Hochfrequenzpulsen auszulassen. Die angegebene nichtäquidistante Hochfrequenz-Pulsfolge hat den Nachteil, daß die Amplitudenkonstanz der Echosignale schwer zu optimieren ist. Ferner fallen in der Auslesephase jeweils mehrere Echos zusammen, so daß eine saubere Auswertung zur Bildgewinnung praktisch nicht möglich ist. Außerdem wird durch die kleinen Flipwinkel bei der Anregung das Signal/Rausch-Verhältnis sehr ungünstig.

Aus der US-Patentschrift 5,212,448 ist eine Pulssequenz bekannt, bei der jeweils unter Schichtselektionsgradienten eine Reihe von Anregungs-Hochfrequenzpulsen eingestrahlt wird. Durch nachfolgende Anwendung eines Hochfrequenz-Inversionspulses werden die angeregten Spins zeitlich nacheinander refokussiert.

In dem Artikel "QUEST - A Quick Echo Split Imaging Technique" in Book of Abstract, page 433, Annual Meeting of the Society of Magnetic Resonance and Medicine, 1992, ist ebenfalls eine Pulssequenz beschrieben, bei der während einer Anregephase eine Folge von zeitlich nicht äquidistanten Anregepulsen und ein erster Gradient eingeschaltet werden. Durch jeden dem ersten Anregepuls nachfolgenden Anregepuls wird die vorhandene Spinmagnetisierung in Teilkollektive aufgespalten. Während der Auslesephase folgt unter einem weiteren Gradienten eine zeitlich gestaffelte Refokussierung der einzelnen Teilkollektive. Dabei kann nach einer einzigen Anregephase eine Vielzahl von Kernresonanzsignalen gewonnen werden, so daß eine kurze Bildaufnahmezeit möglich wird. Die Anforderungen an die Gradientenelektronik bleiben gering. Dieses Verfahren hat jedoch den Nachteil, daß durch die zunehmende Aufspaltung in Teilkollektive die gewonnenen Signale nur schwer auszuwerten sind.

Aufgabe der Erfindung ist es, eine Pulssequenz so auszugestalten, daß bei geringen Hardware-Anforderungen eine kurze Aufnahmezeit erreicht wird.

Ausführungsbeispiele der Erfindung werden nachfolgend anhand der Figuren 1 bis 22 näher erläutert. Dabei zeigen:

Figuren 1 bis 5      eine Pulssequenz mit Anregung der Kernspins nur in der ersten Phase,

Figuren 6 bis 9      ein Ausführungsbeispiel der Erfindung mit Anregung der Kernspins in der ersten und der dritten Phase,

Figuren 10 bis 14      ein weiteres Ausführungsbeispiel der Erfindung

Figuren 15 und 16      ein Ausführungsbeispiel mit Vorsättigung,

Figur 17      ein Ausführungsbeispiel mit einem Präparationspuls,

Figur 18      die Segmentierung des k-Raums,

Figuren 19 und 20      die Einordnung von Kernresonanzsignalen in den k-Raum bei teilweiser Akquisition,

Figur 21      das Frequenzspektrum einer Anrege-Pulsfolge mit konstantem Flipwinkel, und

Figur 22      das Frequenzspektrum einer Anrege-Pulsfolge mit optimierter Flipwinkelverteilung.

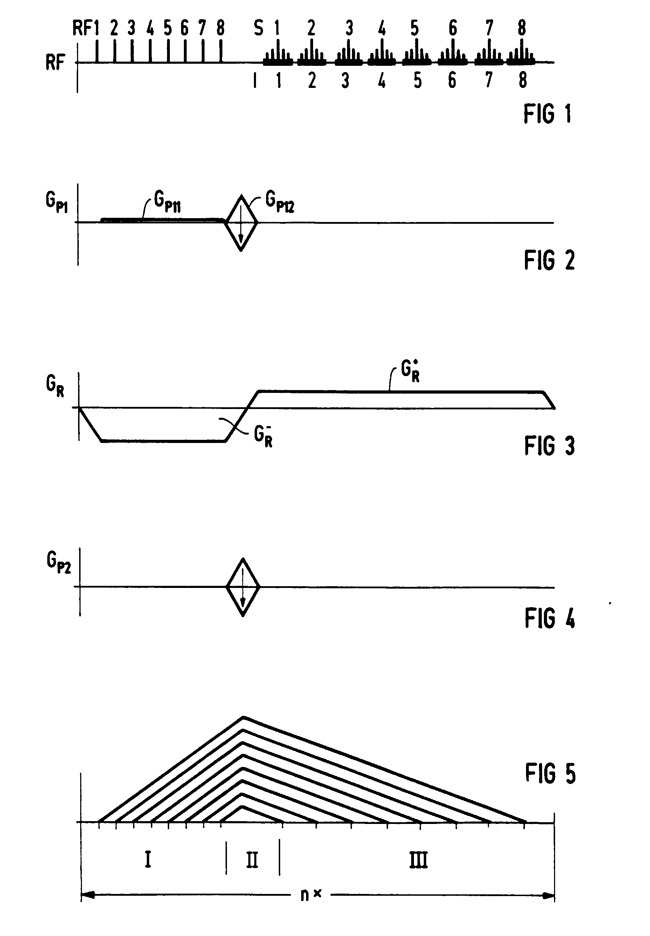

Zur Erläuterung der Erfindung wird zunächst eine Pulssequenz nach den Figuren 1 bis 5 beschrieben, die jedoch kein Ausführungsbeispiel der Erfindung darstellt. Dabei wird - wie in Figur 1 dargestellt - auf ein Untersuchungsobjekt zunächst eine Folge von sogenannten "harten" Hochfrequenzpulsen, im dargestellten Fall acht Hochfrequenzpulsen RF1 bis RF8, eingestrahlt. Unter "harten" Hochfrequenzpulsen versteht man solche mit einem breitbandigen Frequenzspektrum, die auch unter der Wirkung von Gradienten nicht schichtselektiv werden. Hinweise für die Auslegung von Hochfrequenzpulsen für die Anregung von Kernspins sind beispielsweise in dem Artikel "Parameter Relations for the Shinnar-Le Roux Selective Excitation Pulse Design Algorithm" in IEEE Transactions on Medical Imaging, Vol. 10, No. 1, March 1991, gegeben. Die Hochfrequenzpulse RF1 bis RF8 weisen einen kleinen Flipwinkel von deutlich unter 90°, z.B. von 6° auf.

Während der Einstrahlung der Hochfrequenzpulse (als Phase I bezeichnet) sind ein Gradient $G_{P11}$ in einer ersten Phasencodierrichtung $G_{P1}$ und ein negativer Gradient $G_R^-$ in Readout-Richtung eingeschaltet. Wie bereits erwähnt, bleiben aber die Hochfrequenzpulse RF1 bis RF8 nicht-selektiv.

In Figur 5 ist die Phasenlage der angeregten Kernspins bezüglich der Readout-Richtung dargestellt. Unter der Wirkung des Gradienten $G_R^-$ dephasieren die Kernspins in der Phase I zunehmend.

In einer Phase II wird ein Gradient $G_{P12}$ in der ersten Phasencodierrichtung und ein Gradient $G_{P2}$ in der zweiten Phasencodierrichtung eingeschaltet. Ferner wird die Richtung des Gradienten in der Readout-Richtung $G_R$ umgeschaltet. Während der Phase III rephasieren die Kernspins nacheinander unter der Wirkung des Gradienten $G_R^+$. Zu den Zeitpunkten der Rephasierung werden die entstehenden Kernresonanzsignale S1 bis S8 in den Ausleseintervallen I1 bis I8 abgetastet. Eine Betrachtung der Figur 5 zeigt, daß dabei das erste Kernresonanzsignal S1 durch Refokussierung der Anregung mit dem letzten Hochfrequenzpuls RF8 entsteht, das letzte Kernresonanzsignal S8 durch Refokussierung der mit dem ersten Hochfrequenzpuls RF1 angeregten Kernspins.

Die Kernresonanzsignale S1 bis S8 sind durch den Gradienten $G_R^+$ in dessen Richtung frequenzcodiert. Ferner sind sie in der ersten und zweiten Phasencodierrichtung $G_{P1}$ und $G_{P2}$ phasencodiert. In der ersten Phasencodierrichtung $G_{P1}$ werden sie durch den Gradienten $G_{P11}$ unterschiedlich phasencodiert, da sich die wirksame Dauer dieses Gradienten von Kernresonanzsignal zu Kernresonanzsignal unterscheidet. Durch den Phasencodiergradient $G_{P12}$ wird den Kernresonanzsignalen S1-S8 eine zusätzlich Phase aufgeprägt, die für alle Kernresonanzsignale S1 bis S8 gleich ist.

Die dargestellte Sequenz wird n-mal durchgeführt. Dabei wird der gesamte dreidimensionale k-Raum durch Fortschalten des Gradienten $G_{P12}$ abgetastet.

Dabei ist eine extrem schnelle Datenerfassung möglich. Da die Gradientenfelder wesentlich seltener als die Anregungen geschaltet werden (z.B. eine Umschaltung des Gradienten GR in Ausleserichtung nach acht Anregungen) und keine hohen Änderungsraten benötigt werden, werden an den Gradientenverstärker keine besonderen Anforderungen gestellt.

Die Längsmagnetisierung wird laufend durch $T_1$-Relaxationen nachgefüllt, so daß ein steady-state-Zustand der Längsmagnetisierung entsteht. Somit kann die Messung prinzipiell ohne Zeitverzug beliebig oft wiederholt werden, wobei jede Messung von der gleichen Längsmagnetisierung ausgeht. Durch abschnittweise Erfassung des für die Bilderzeugung nötigen Datensatzes sind extrem kurze Echozeiten (Zeiten zwischen Anregen und Auslesen des Signals) möglich, so daß die Signalintensität und die Bildqualität wenig durch T2*-Zerfall, Feldinhomogenitäten, Diffusion und Fluß-Artefakte beeinflußt wird. Ferner kann die Variation der Echozeit innerhalb der Kohärenzzeit der chemischen Verschiebung gehalten und diesbezüglich Artefakte weitgehend vermieden werden. Beim dargestellten Beispiel mit acht Echos pro Teilsequenz und 64 k-Raum-Zeilen nach den Figuren 1 bis 5 können zum Beispiel Echozeiten im Bereich zwischen 2,277 ms und 18,517 ms erreicht werden, wodurch sich eine effektive k-Raum-Abtastbandbreite von 61,6 Hz pro Pixel in Phasencodierrichtung ergibt. Die chemische Verschiebung zwischen Fett und Wasser von 140 Hz bei einer Feldstärke von 1 T verursacht somit nur eine Bildverzerrung von etwa 2,5 Pixeln.

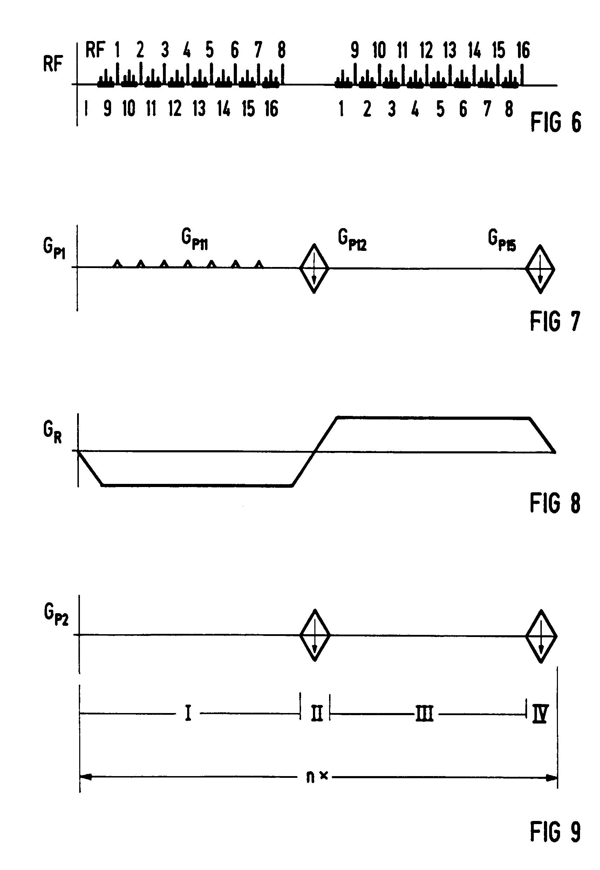

In den Figuren 6 bis 9 ist ein erstes Ausführungsbeispiel der Erfindung dargestellt. Im Unterschied zur Pulssequenz nach den Figuren 1 bis 5 werden hierbei in der Phase III in den Pausen zwischen den Ausleseintervallen I1 bis I8 weitere Hochfrequenzsignale RF9 bis RF16 eingestrahlt. Ferner werden im Intervall I während der Ausleseintervalle I9 bis I16 ebenfalls Kernresonanzsignale ausgelesen. Dies ist natürlich nur möglich, wenn der dargestellten Teilsequenz eine gleichartige Teilsequenz vorausgeht. Die Kernresonanzsignale in den Ausleseintervallen I9 bis I16 in der dargestellten Teilsequenz entstehen dann durch Rephasierung der durch die Hochfrequenzpulse RF9 bis RF16 der vorangehenden Teilsequenz angeregten Kernspins. Mit dieser Art der Anregung kann die doppelte Zahl von Kernresonanzsignalen ohne Verlängerung der Meßzeit gewonnen werden. Das hier erforderliche schnelle Umschalten des Hochfrequenz-Sende- und Empfangssystems ist wesentlich unproblematischer als Gradientenschaltungen in EPI-Messungen.

Bei diesem Ausführungsbeispiel erfolgt die Phasencodierung in der Phase I, wie in Figur 7 sichtbar, nicht durch einen durchgeschalteten Phasencodiergradienten in der ersten Phasencodierrichtung $G_{P1}$, sondern durch einzelne Pulse $G_{P11}$. Damit wird die Phasencodierung im k-Raum von Zeile zu Zeile schrittweise fortgeschaltet, d.h., es erfolgt nicht wie im Beispiel nach Figur 2 eine schräge Abtastung des k-Raums.

Bei diesem Ausführungsbeispiel reicht es aus, wenn in einer der Phasen I oder III ein Phasencodiergradient in der ersten Phasencodierrichtung $G_{P1}$ geschaltet wird, da dieser sowohl auf die in der Phase I abgetasteten Kernresonanzsignale wirkt als auch die Kernspins phasencodiert, die in der Phase I angeregt werden. Im Unterschied zu Figur 2 ist bei der Phasencodierung nach den Figuren 7 und 9 lediglich auch nach der Phase III in einer Phase IV ein Phasencodiergradient $G_{P2}$ vorgesehen, der die Phase für den gesamten vorhergehenden Pulszug einheitlich weiterschaltet. Es wäre natürlich auch eine Phasencodierung möglich, bei der der Phasenkodiergradient während der jeweiligen Phase eingeschaltet bleibt.

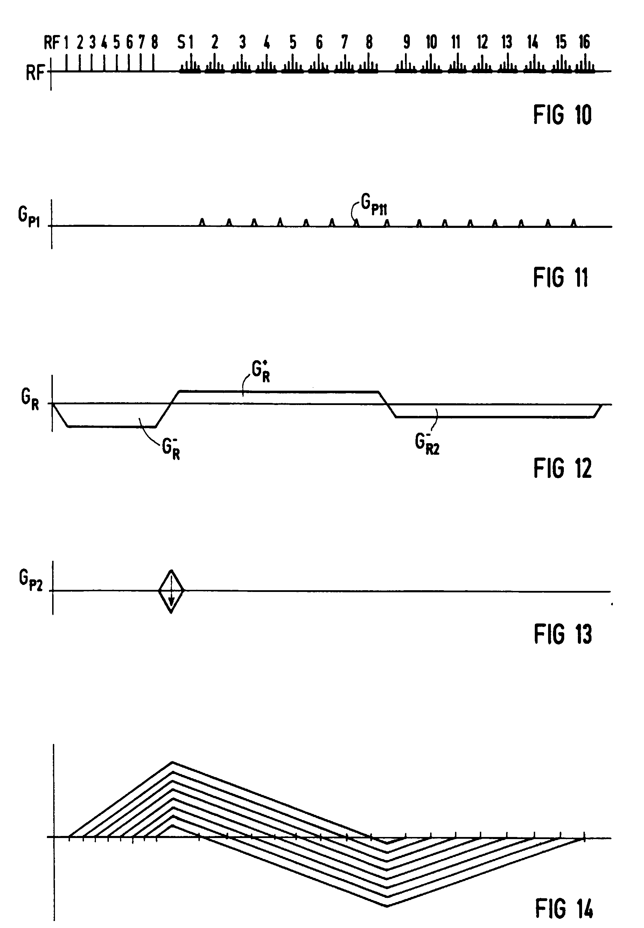

Ein weiteres Ausführungsbeispiel der Erfindung ist in den Figuren 10 bis 14 dargestellt. Der Übersichtlichkeit wegen sind dabei in der ersten Phase nur Anregepulse RF1 bis RF8, in der dritten Phase nur Kernresonanzsignale S1 bis S16 dargestellt, obwohl in beiden Phasen sowohl Anregen als auch Auslesen von Kernresonanzsignalen geschieht. Dabei wird entsprechend Figur 12 der Gradient $G_R$ in Ausleserichtung nicht nur einmal, sondern zweimal invertiert ($G_{R2}^-$). Damit werden, wie in Figur 14 dargestellt, die unter der Wirkung des Gradienten $G_R^+$ dephasierten Spins wieder rephasiert, so daß eine weitere Gruppe von Kernresonanzsignalen S9 bis S16 entsteht. Dabei können natürlich durch weitere Invertierungen des Gradienten $G_R$ in Ausleserichtung noch weitere Kernresonanzsignale erzeugt werden. Im dargestellten Ausführungsbeispiel erfolgt die Phasencodierung in der ersten Phasencodierrichtung durch kurze Phasencodierpulse $G_{P11}$ vor jedem Kernresonanzsignal S. Damit wird die Phasencodierung im k-Raum von Zeile zu Zeile schrittweise fortgeschaltet.

In der zweiten Phasencodierrichtung ist ein Phasencodiergradient $G_{P2}$ vor der dritten Phase eingeschaltet. Dieser codiert die Kernresonanzsignale S1 bis S16 einheitlich in der zweiten Phasencodierrichtung.

Mit dem Ausführungsbeispiel nach den Figuren 10 bis 14 können pro Anregung noch mehr Kernresonanzsignale gewonnen werden als bei dem vorhergehenden Ausführungbeispiel.

Im Prinzip werden die in einer Teilsequenz angeregten Kernspins nicht nur in der nächsten Teilsequenz rephasiert, sondern noch mehrfach in den nachfolgenden Teilsequenzen, wenn auch die dabei entstehenden Kernresonanzsignale aufgrund des T2*-Zerfalls eine stark abnehmende Amplitude haben. Durch diese zusätzlichen Signale können jedoch störende Kohärenzen auftreten. Um dies zu vermeiden, können die Phasen der ganzen Pulszüge in aufeinanderfolgenden Phasen I, III der Teilsequenzen gedreht werden. Entsprechend muß dann auch die Bezugsphase bei der Demodulation der jeweils zugeordneten Echos gedreht werden. Durch dieses auch als Hochfrequenz-Spoiling bezeichnete Verfahren werden störende Kohärenz-Artefakte vermieden. Die Entstehung und Vermeidung von Kohärenz-Artefakten ist in dem Artikel "Elimination of Transverse Coherences in FLASH-MRI" in Magnetic Resonance in Medicine, 8, pp. 248-260, (1988), genauer beschrieben.

Bei dem beschriebenen Verfahren der Echoerzeugung variieren die Echozeiten. Bei einer Betrachtung der Figur 5 wird deutlich, daß beispielsweise die Echozeit zwischen dem ersten Hochfrequenzpuls RF1 und dem zugeordneten Echo S8 deutlich größer als zwischen dem Hochfrequenzpuls RF8 und dem zugeordneten Echo S1. Mit längerer Echozeit nimmt jedoch die Echoamplitude ab. Die unterschiedlichen Amplituden sind unerwünscht und können dadurch weitgehend vermieden werden, daß die früheren Hochfrequenzpulse einen höheren Flipwinkel aufweisen als die späteren, d.h., daß der Flipwinkel vom Hochfrequenzpuls RF1 bis zum Hochfrequenzpuls RF8 abnimmt.

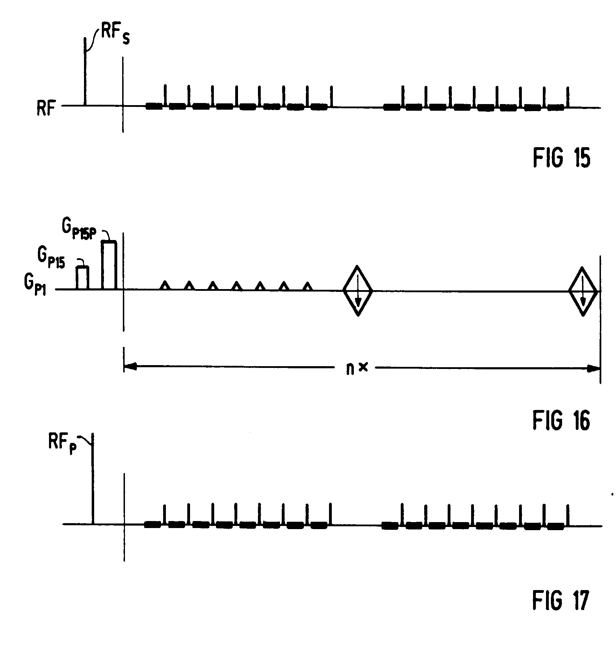

Die Pulssequenzen nach dem erfindungsgemäßen Verfahren sind grundsätzlich nicht schichtselektiv, so daß normalerweise ein dreidimensionales Volumen angeregt und ausgelesen wird. In manchen Fällen sollen jedoch bestimmte Schichten ausgewählt bzw. benachbarte Schichten ausgeblendet werden. Eine Ausblendung von Schichten bzw. Bereichen kann man erreichen, indem man entsprechend der Pulssequenz nach den Figuren 15 und 16 einen Bereich bzw. Schicht selektiv sättigt. Dazu kann z.B. der eigentlichen Pulssequenz ein frequenzselektiver Hochfrequenzpuls $RF_S$ vorangestellt werden, der unter der Wirkung eines Schichtselektionsgradienten $G_{P1S}$ eingestrahlt wird. Anschließend wird ein Spoiler-Gradient $G_{P1Sp}$ eingeschaltet, der die durch die Anregung erzeugte Magnetisierung dephasiert. Damit wird eine Schicht gesättigt, deren Lage und Dicke durch die Frequenz- und Bandbreite des Hochfrequenzpulses $RF_S$ und die Amplitude des Gradienten $G_{P1S}$ bestimmt ist. Da in dieser gesättigten Schicht die Kernspins depolarisiert sind, können in der nachfolgenden Pulssequenz in dieser Schicht keine Kernresonanzsignale angeregt werden.

Das Bildkontrastverhalten kann dadurch beeinflußt werden, daß man vor der eigentlichen Meßsequenz die Längsmagnetisierung präpariert. Dazu kann z.B. entsprechend Figur 17 vor der ersten Teilsequenz ein Hochfrequenzpräparationspuls RFp in Form eines 180°-Pulses eingestrahlt werden.

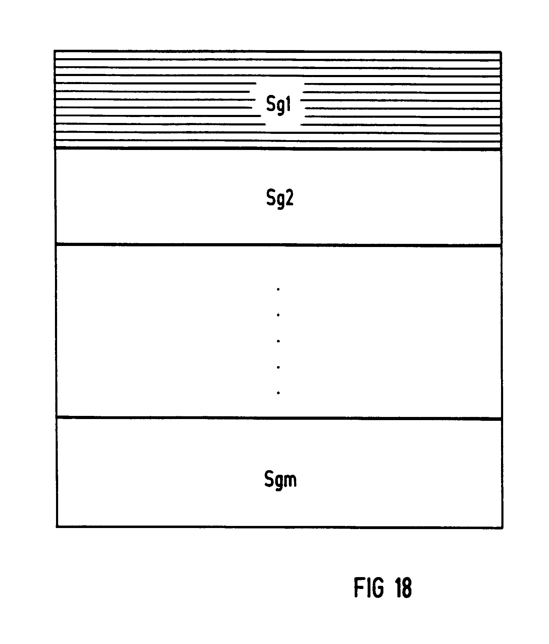

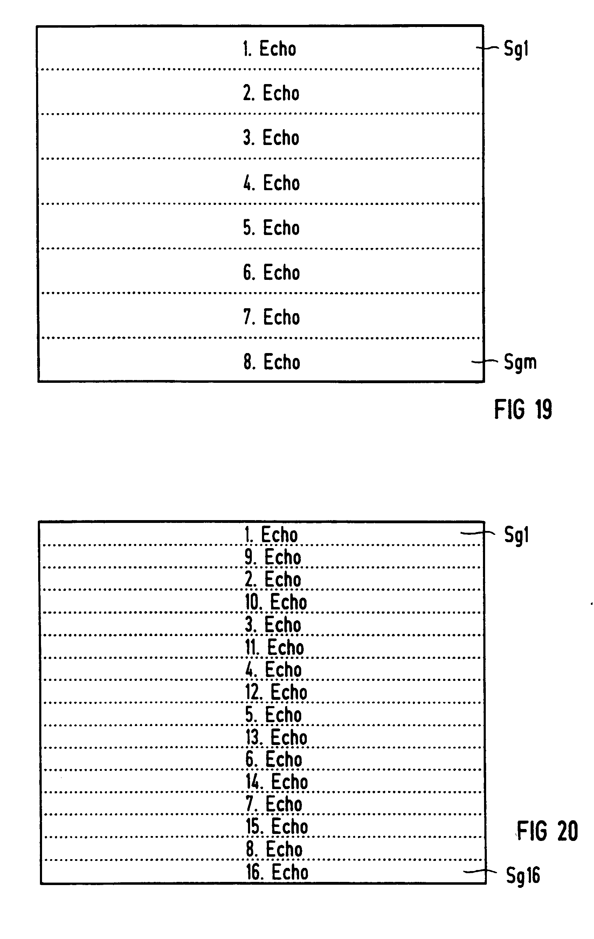

In einer Teilsequenz nach dem beschriebenen Verfahren können typischerweise nicht alle für ein vollständiges dreidimensionales Bild erforderlichen Rohdaten gewonnen werden oder anders ausgedrückt: Es kann nicht der vollständige k-Raum abgetastet werden. Vorteilhafterweise wird daher der k-Raum in der in den Figuren 18 und 19 zweidimensional dargestellten Weise segmentiert, d.h. in einzelne Segmente Sgl bis Sgm eingeteilt, denen jeweils ein zusammenhängender Block von Zeilen zugeordnet ist. Die Anzahl der Segmente Sg entspricht dabei der Anzahl der je Teilsequenz gewonnenen Kernresonanzsignale, im Falle der beispielhaften Pulssequenz nach Figur 1 sind also acht Segmente, im Falle der erfindungsgemäßen Pulssequenz nach Figur 6 sechzehn Segmente vorhanden. Durch aufeinanderfolgende Teilsequenzen werden dann aufeinanderfolgende Zeilen in jedem Segment Sg aufgefüllt, wobei die Teilsequenzen so oft ausgeführt werden, bis alle Zeilen der Rohdatenmatrix gefüllt sind.

Die Zuordnung eines Kernresonanzsignales zu einer Zeile einer Rohdatenmatrix ist durch dessen Phasenfaktor bestimmt. Durch entsprechende Einstellung der Phasenfaktoren kann also die Reihenfolge der Einsortierung beliebig vorgegeben werden. Wie bereits erwähnt, weisen die Kernresonanzsignale innerhalb einer Teilsequenz unterschiedliche Amplituden auf. Größere Amplitudenunterschiede von Zeile zu Zeile einer Rohdatenmatrix sind möglichst zu vermeiden, da dies zu Artefakten im Bild führt. Daher werden die abgetasteten Kernresonanzsignale entsprechend Figur 19 so in die Rohdatenmatrix R eingeordnet, daß alle ersten Echos der einzelnen Teilsequenzen in das erste Segment Sg1, alle zweiten Echos in das zweite Segment Sg2 usw. einsortiert werden.

Im Fall der erfindungsgemäßen Pulssequenz nach Figur 6, wo also sowohl in der Phase I als auch in der Phase III Kernresonanzsignale gewonnen werden, erfolgt die Einordnung nach Figur 20. Dabei werden in das erste Segment Sg1 die ersten Echos aller Teilsequenzen, in das zweite Segment Sg2 die neunten Echos aller Teilsequenzen eingeordnet, da die ersten und die neunten Echos eine weitgehend gleiche Amplitude aufweisen. Dementsprechend werden das zweite und das zehnte Echo, das dritte und das elfte Echo usw. nacheinander in die Segmente Sg1 bis Sg16 eingeordnet.

Eine besondere Ausführungsform ist in Anspruch 14 angegeben.

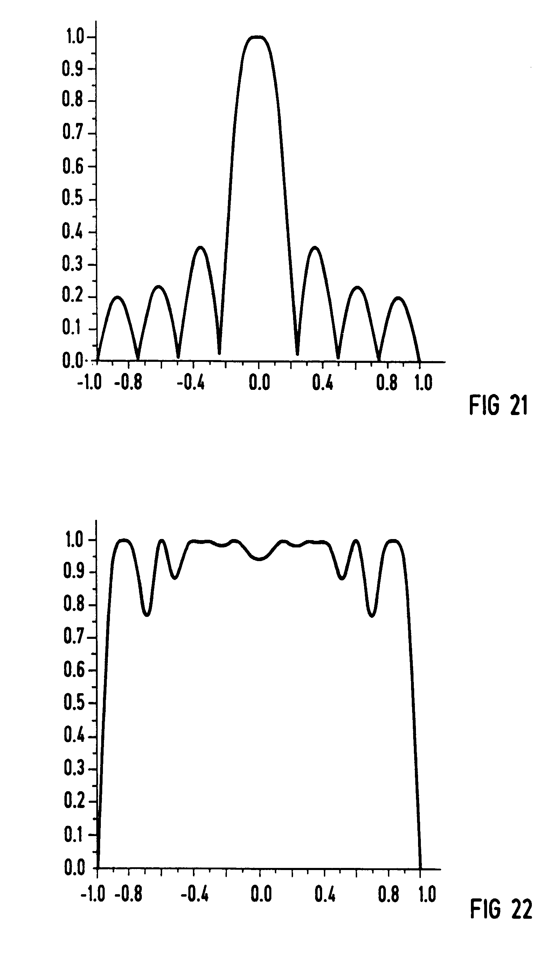

Wenn auch das Spektrum eines einzelnen "harten" Hochfrequenzpulses breitbandig ist, so entsteht durch die Einwirkung eines gesamten Pulszuges wegen dessen Länge dennoch ein verhältnismäßig schmales Spektrum, wie es in Figur 21 dargestellt ist. Dieses Spektrum besteht aus einzelnen Linien, wobei nur aus diesen Spektrallinien ein Signal gewonnen werden kann. Es gibt aber eine Möglichkeit, das Spektrum des gesamten Pulszuges zu verbreitern, nämlich durch Phasenmodulation der einzelnen Pulse. Eine deutliche Verbreiterung kann z.B. mit folgender Phasenfolge erzielt werden:

180°, 45°, (-45°), (-90°), (-90°), (-45°), 45°, 180°

Das mit diesem Pulszug erzielte Anregungsspektrum ist in Figur 22 dargestellt.

Die Phasenmodulation von Hochfrequenzpulsen in einem Pulszug wird auch in dem Artikel "Burst Excitation Pulses" in 10th SMRM Book of Abstracts, Seite 269, 1991 behandelt.

Der besondere Vorteil des dargestellten Verfahren liegt in der im Verhältnis zur Anzahl der ausgelesenen Signale geringen Anzahl von Umschaltungen des Auslesegradienten. Bei allen dargestellten Ausführungsformen weist der Auslesegradient nur vier Rampen je Teilmessung auf. Steile Pulsrampen bedingen aufgrund der Induktivität der Gradientenspulen eine hohe Schaltspannung und damit entsprechende Anforderungen an den Gradientenverstärker und die Spannungsfestigkeit der Gradientenspulen. Bei herkömmlichen schnellen Sequenzen und einem herkömmlichen System Gradientenverstärker-Gradientenspule geht die Rampenzeit, die für die Anregung und das Auslesen von Kernresonanzsignalen normalerweise nicht zur Verfügung steht, bereits stark in die Gesamtzeit einer Pulssequenz ein. Da bei der hier dargestellten Pulssequenz die Anzahl der Signale deutlich größer ist als die Anzahl der Rampen, fallen die Rampenzeiten weniger ins Gewicht. Dies wird im folgenden näher betrachtet.

Eine Pulssequenz kann beurteilt werden nach einer Größe $\eta$, die man als Abtasteffizienz bezeichnen könnte:

$$\eta = \frac{\text{effektive Auslesezeit}}{\text{gesamte Akquisitionszeit}}$$

Diese Größe wird durch die nicht für die Abtastung der Kernresonanzsignale zur Verfügung stehende Zeit begrenzt. Die Bedeutung des Faktors $\eta$ erkennt man, wenn man die direkt das Signal-zu-Rausch-Verhältnis bestimmende effektive Empfängerbandbreite $\Delta f$ in Abhängigkeit vom oben definierten Abtastwirkungsgrad $\eta$ und der Repetitionszeit $T_R$ der Sequenz ausdrückt:

$$\Delta f = \frac{1}{\eta \cdot T_R}$$

In der Praxis wird mit kürzeren Meßzeiten die Abtasteffizienz aufgrund der relativ konstanten, nicht für die Abtastung zur Verfügung stehenden Rampenzeiten verschlechtert. Auch bei zweidimensionalen EPI-Verfahren, die gegenwärtig das Optimum bezüglich Meßzeit und Signal intensität darstellen, liegt $\eta$ für einen sinusförmigen Auslesegradienten nur bei unter 0,637. Bei der Pulssequenz nach den Figuren 1 bis 5 werden während einer Halbwelle des Auslesegradienten $G_R$ nur Hochfrequenzpulse eingestrahlt und während der anderen Halbwelle nur Signale ausgelesen. Wenn beide Gradientenhalbwellen gleiche Amplituden haben, bleibt die Abtasteffizienz kleiner 0,5. Wenn man aber die Amplitude des Auslesegradienten $G_R^-$ in der Phase I größer macht als in der Phase III, wird die Phase I kürzer, so daß die Abtasteffizienz über 0,5 erhöht werden kann.

Bei der Pulssequenz nach den Figuren 6 bis 9 dagegen erstreckt sich die Abtastphase sowohl auf die Phase I als auch auf die Phase III. Damit ist diese Technik wesentlich schneller und effizienter, aber technisch anspruchsvoller. Normalerweise liegt die Umschaltzeit für den Sende-Empfangs-Duplexer im Bereich von wenigen Mikrosekunden, eine Ausleseperiode jedoch bei einigen Millisekunden, so daß das Ziel der kontinuierlichen Abtastung nahezu erreicht werden kann.

Eine Analyse der dynamischen $T_1$-Relaxation und des steady-state-Zustands in der Longitudinal-Richtung kann bei kleinen Flipwinkeln der Hochfrequenzpulse ohne großen Fehler dadurch vereinfacht werden, daß diese als mit einer mittleren Repetitionszeit $T_R$ äquidistant beabstandet betrachtet werden. Bei einer Repetitionszeit $T_R$, die wesentlich kleiner als die Längsrelaxationszeit $T_1$ ist und mit einer Empfängerbandbreite $\Delta f$, ergibt sich das optimale Signal/Rausch-Verhältnis pro Zeiteinheit für eine dreidimensionale Abtastung bei M Schichten und Fourier-Rekonstruktion zu:

$$\frac{S}{N \cdot \sqrt{T_R}} = \sqrt{\frac{\eta \cdot T_R \cdot M}{2\,T_1}}$$

Ein sequenzunabhängiger Skalierungsfaktor wurde weggelassen. Eine ähnliche Betrachtung beim Mehrschichtzweidimensionalen EPI-Verfahren mit einer voll relaxierten Anfangsmagnetisierung ergibt:

$$\frac{S}{N \cdot \sqrt{T_R}} = \frac{1}{2}\,\sqrt{\eta}$$

Für Vergleichszwecke ist hier mit $T_R$ der mittlere Echoabstand bezeichnet. Der Faktor 1/2 wurde eingeführt, um den in der Praxis beobachteten Signalverlust von etwa 50% zu berücksichtigen. Dieser wird dem starken T2*-Zerfall und der Fettsättigung zugeschrieben.

Im folgenden wird zum Vergleich ein Objekt mit einer Relaxationszeit $T_1$ von 500 ms betrachtet. Dieses wird mit 64x64x128 k-Raumpunkten sowohl durch ein zweidimensionales Mehrschicht-Spinecho EPI mit einer Abtasteffizienz von $\eta$=0,41 und mit dem hier beispielhaft erwähnten Verfahren abgetastet. Bei einer tatsächlich implementierten Pulssequenz nach den Figuren 1 bis 5 wurde eine Repetitionszeit $T_R$ von 2,63 ms und eine Abtasteffizienz $\eta=0{,}59$ erreicht. Mit diesen Parametern ist das bezüglich der Meßzeit normalisierte Signal/Rauschverhältnis für beide Techniken etwa identisch, d.h. 0,31 für das hier beispielhaft erwähnte dreidimensionale Verfahren und 0,32 für EPI. Das hier erwähnte 3D-Bildgebungsverfahren und EPI führt demnach bei gleicher Meßzeit zu Bildern mit ähnlichem Signal/Rauschverhältnis.

Die beispielhafte Pulssequenz nach den Figuren 1 bis 5 mit 128 Partitionen wurde auf einem herkömmlichen Kernspintomographiegerät Siemens Magnetom Impact mit einer Gradientenfeldstärker von 15 mT pro Meter und 15 T/m·s Gradientenänderungsrate implementiert. In einer Teilsequenz wurden acht "harte" Hochfrequenzpulse mit einem Flipwinkel von $\alpha=6°$ und einer Dauer von jeweils 10 µs eingestrahlt. Die eingestrahlte Hochfrequenzleistung SAR (Specific Absorption Rate) lag weit unter den Grenzwerten der FDA (Food and Drug Administration). Es wurde eine Abtasteffizienz von $\eta=0{,}59$ erreicht. Die Digitalisierung von 128x64x128 k-Raumpunkten bei 83 kHz benötigte eine Meßzeit von insgesamt 21,5 s oder 168 ms pro Schicht.

Mit dieser Pulssequenz konnte eine isotropische lineare Auflösung bis zu 2 mm für ein minimales Betrachtungsfenster (field of view) von 260x260x260 mm$^3$ erreicht werden. Bilder aus dem menschlichen Kopf mit einem Betrachtungsfeld (field of view) von 280x280 mm und 2,15 mm effektiver Einzelschichtdicke zeigten ein Signal/Rausch-Verhältnis S/N von etwa 30 bis 40.

Auf derselben Anlage wurde eine erfindungsgemäße Pulssequenz nach den Figuren 6 bis 9 implementiert. Die Flipwinkel betrugen $\alpha=5°$. Bei einer Abtastrate von 200 kHz ergab sich ein Abbildungsvolumen (volume of view) von 160x320x320 mm$^3$. Für die Messung von 16x64x128 k-Raumpunkten wurden insgesamt 1,35 s (84 ms pro Schicht) benötigt. Die mittlere Echorepetitionszeit lag bei $T_R=1{,}31$ ms. Aufgrund von Hardware-Einschränkungen bei der benutzten Oberflächenspule fiel die an sich mögliche Abtasteffizienz von $\eta=0{,}76$ auf $\eta=0{,}49$. Es waren nur schwache Artefakte aufgrund chemischer Verschiebung zu erkennen, so daß weder ein Shimmen des Grundfeldes noch Fettunterdrückung notwendig war. Mit einer zirkular polarisierten Hochfrequenzspule konnte ein normiertes Signal/Rausch-Verhältnis von etwa 25 bei einer Schichtdicke von 10 mm erreicht werden. Eine Serie von bis zu 72 aufeinanderfolgenden 3D-Pulssequenzen (1152 Bilder in 97 Sekunden) zeigte eine konstante Bildqualität. Damit wurde gezeigt, daß sich während der Messung ein steady-state-Zustand in longitudinaler Richtung einstellt.

**Patentansprüche**

1.  Pulssequenz zur Bildgewinnung mit einem Kernspinresonanzgerät mit folgenden Schritten:

    a) während einer ersten Phase (I) wird eine Folge von harten Hochfrequenzpulsen (RF1-RF8) eingestrahlt, wobei gleichzeitig ein Gradient in einer ersten Richtung ($G_R{}^-$) eingeschaltet ist,

    b) während einer dritten Phase (III) wird der Gradient in der ersten Richtung umgekehrt ($G_R{}^+$) und die in einer Folge von Abtastintervallen (I1-I8) entstehenden Kernspinresonanzsignale werden unter der Wirkung des umgekehrten Gradienten ($G_R{}^+$) abgetastet,

    c) die aus den Schritten a und b bestehende Teilsequenz wird n-mal wiederholt,

    **dadurch gekennzeichnet**, daß auch während der dritten Phase (III) zwischen den Abtastintervallen (I1-I8) Hochfrequenzpulse (RF9-RF16) eingestrahlt werden und daß auch in der ersten Phase während Abtastintervallen (I9-I16) Kernresonanzsignale abgetastet werden.

2.  Pulssequenz nach Anspruch 1, **dadurch gekennzeichnet**, daß in einer zwischen der ersten und der dritten Phase (I, III) liegenden zweiten Phase (II) und in einer nach der dritten Phase (III) liegenden vierten Phase (IV) jeweils ein Phasencodiergradient ($G_{P12}$, $G_{P15}$) in einer zweiten, zur ersten Richtung senkrechten Richtung eingeschaltet wird, wobei diese Phasencodiergradienten ($G_{P12}$, $G_{P15}$) von Teilsequenz zu Teilsequenz eine variierende Amplituden-Zeit-Fläche aufweisen.

3.  Pulssequenz nach Anspruch 2, **dadurch gekennzeichnet**, daß während der zweiten Phase (II) und während der vierten Phase (IV) zusätzlich jeweils ein Phasencodiergradient ($G_{P2}$) in einer zur ersten und zur zweiten Richtung senkrechten dritten Richtung eingeschaltet wird, der eine von Teilsequenz zu Teilsequenz variierende Amplituden-Zeit-Fläche aufweist.

4.  Pulssequenz nach einem der Ansprüche 1 bis 3, **dadurch gekennzeichnet**, daß während der ersten und/oder der dritten Phase (I, III) ein Phasencodiergradient ($G_{P11}$) in einer zweiten, zur ersten Richtung senkrechten Richtung eingeschaltet wird.

**5.** Pulssequenz nach Anspruch 4, **dadurch gekennzeichnet**, daß der Phasencodiergradient ($G_{P11}$) während der jeweiligen Phase eingeschaltet bleibt.

**6.** Pulssequenz nach Anspruch 4, **dadurch gekennzeichnet**, daß der Phasencodiergradient ($G_{P11}$) aus Einzelpulsen zwischen den Ausleseintervallen (I1-I16) besteht.

**7.** Pulssequenz nach einem der Ansprüche 1 bis 6, **dadurch gekennzeichnet**, daß die abgetasteten Kernresonanzsignale entsprechend ihrer Phasencodierung im k-Raum in je eine Zeile einer Rohdatenmatrix geschrieben werden, wobei die Rohdatenmatrix in eine Anzahl von Segmenten (Sgl-Sgm) mit jeweils n zusammenhängenden Zeilen eingeteilt ist, wobei die Anzahl der Segmente (Sgl-Sgm) der Anzahl unterschiedlich phasencodierter Kernresonanzsignale (Sg1-Sg16) je Teilsequenz entspricht und daß eine Phasencodierung der Kernresonanzsignale in der Phase III und ggf. IV derart durchgeführt wird, daß damit die Zuordnung der nachfolgenden Kernresonanzsignale (Sgl-Sgl6) zu einem Segment (Sgl-Sgm) festgelegt ist und daß eine Phasencodierung in den Phasen I bis IV derart durchgeführt wird, daß damit die Zuordnung der Kernresonanzsignale (Sgl-Sgl6) zu den einzelnen Zeilen des jeweiligen Segments (Sgl-Sgm) festgelegt ist.

**8.** Pulssequenz nach Anspruch 7, **dadurch gekennzeichnet**, daß die Einordnung der Zeilen in der Rohdatenmatrix derart erfolgt, daß die Amplitudenunterschiede der Kernresonanzsignale benachbarter Zeilen der Rohdatenmatrix möglichst gering sind.

**9.** Pulssequenz nach einem der Ansprüche 1 bis 8, **dadurch gekennzeichnet**, daß die Hochfrequenzpulse (RF1-RF16) derart phasenmoduliert werden, daß das Anregespektrum des Pulszuges verbreitert wird.

**10.** Pulssequenz nach einem der Ansprüche 1 bis 9, **dadurch gekennzeichnet**, daß die Hochfrequenzpulse (RF1-RF16) innerhalb der ersten und gegebenenfalls in der dritten Phase (I, III) eine von Hochfrequenzpuls zu Hochfrequenzpuls variierende Amplitude aufweisen.

**11.** Pulssequenz nach einem der Ansprüche 1 bis 10, **dadurch gekennzeichnet**, daß die Hochfrequenzpulse in aufeinanderfolgenden Phasen in der Phase gedreht werden.

**12.** Pulssequenz nach einem der Ansprüche 1 bis 11, **dadurch gekennzeichnet**, daß die Phasencodierung der Kernspins nach jeder Auslesephase (I, III) zurückgesetzt wird.

**13.** Pulssequenz nach einem der Ansprüche 1 bis 12, **dadurch gekennzeichnet**, daß durch Präparation der Längsmagnetisierung vor mindestens einer Teilsequenz eine Änderung des Bildkontrastverhaltens herbeigeführt wird.

**14.** Pulssequenz nach einem der Ansprüche 1 bis 13, **dadurch gekennzeichnet** , daß durch Variierung des Zeitabstandes zwischen Anregung und Ausleseperioden unter den Teilsequenzen die effektiven Echozeiten von k-Raum-Zeile zu k-Raum-Zeile kontinuierlich variieren.

## Claims

**1.** Pulse sequence for obtaining an image with a nuclear spin resonance apparatus comprising the following steps:

a) during a first phase (I), a sequence of hard radio-frequency pulses (RF1 - RF8) is radiated, a gradient being activated in a first direction ($G_R{}^-$) at the same time,

b) during a third phase (III), the gradient in the first direction is inverted ($G_R{}^+$) and the nuclear spin resonance signals produced in a sequence of sampling intervals (I1 - I8) are sampled while being acted on by the the inverted gradient ($G_{R+}$),

c) the sub-sequence comprising the steps a and b is repeated n times,

characterized in that radio-frequency pulses (RF9 - RF16) are also radiated during the third phase (III) between the sampling intervals (I1 - I8) and in that nuclear magnetic resonance signals are also sampled in the first phase during the scanning intervals (I9 - I16).

2. Pulse sequence according to Claim 1, characterized in that, in a second phase (II) situated between the first and the third phases (I, III) and in a fourth phase (IV) situated after the third phase (III), a phase-coding gradient ($G_{P12}$, $G_{P15}$) is activated in each case in a second direction perpendicular to the first direction, said phase-coding gradients ($G_{P12}$, $G_{P15}$) having varying amplitude/time area from sub-sequence to sub-sequence.

3. Pulse sequence according to Claim 2, characterized in that, during the second phase (II) and during the fourth phase (IV), a phase-coding gradient ($G_{P2}$) is additionally activated in each case in a third direction perpendicular to the first and to the second directions, which phase-coding gradient ($G_{P2}$) has varying amplitude/time area from sub-sequence to sub-sequence.

4. Pulse sequence according to one of Claims 1 to 3, characterized in that, during the first and/or the third phases (I, III), a phase-coding gradient ($G_{P11}$) is activated in a second direction perpendicular to the first direction.

5. Pulse sequence according to Claim 4, characterized in that the phase-coding gradient ($G_{P11}$) remains activated during the respective phase.

6. Pulse sequence according to Claim 4, characterized in that the phase-coding gradient ($G_{P11}$) is composed of individual pulses between the read-out intervals (I1 - I16).

7. Pulse sequence according to one of Claims 1 to 6, characterized in that the sampled nuclear magnetic resonance signals are written into one line in each case of a raw data matrix in accordance with their phase coding in the k-space, the raw data matrix being divided into a number of segments (Sg1 - Sgm) each having n coherent rows, the number of segments (Sg1 - Sgm) corresponding to the number of differently phase-coded nuclear magnetic resonance signals (Sg1 - Sg16) for each sub-sequence, and in that a phase coding of the nuclear magnetic resonance signals in phase III and, possibly, IV is performed in such a way that the allocation of the successive nuclear magnetic resonance signals (Sg1 - Sg16) to a segment (Sg1 - Sgm) is thereby determined and in that a phase coding in phases I to IV is performed in such a way that the allocation of the nuclear magnetic resonance signals Sg1 - Sg16 to the individual rows of the respective segment (Sg1 - Sgm) is thereby determined.

8. Pulse sequence according to Claim 7, characterized in that the rows are ordered in the raw data matrix in such a way that the amplitude differences of the nuclear magnetic resonance signals of adjacent rows of the raw data matrix are as small as possible.

9. Pulse sequence according to one of Claims 1 to 8, characterized in that the radio-frequency pulses (RF1 - RF16) are phase-modulated in such a way that the excitation spectrum of the pulse train is widened.

10. Pulse sequence according to one of Claims 1 to 9 characterized in that the radio-frequency pulses (RF1 - RF16) within the first phase (I) and, possibly, in the third phase (III) have an amplitude which varies from radio-frequency pulse to radio-frequency pulse.

11. Pulse sequence according to one of Claims 1 to 10, characterized in that the radio-frequency pulses are rotated in phase in successive phases.

12. Pulse sequence according to one of Claims 1 to 11, characterized in that the phase coding of the nuclear spins is reset after every read-out phase (I, III).

13. Pulse sequence according to one of Claims 1 to 12, characterized in that a change in the image contrast characteristic is effected by preparation of the longitudinal magnetization prior to at least one sub-sequence.

14. Pulse sequence according to one of Claims 1 to 13, characterized in that the effective echo times vary continuously from k-space row to k-space row as a result of varying the time interval between excitation and read-out periods among the sub-sequences.

**Revendications**

1. Séquence d'impulsions pour obtenir une image par un appareil à résonance magnétique nucléaire comportant les étapes suivantes :

   a) lors d'une première phase (I), une suite d'impulsions (RF1 à RF8) dure à haute fréquence sont envoyées en un faisceau, un gradient étant en même temps établi dans une première direction ($G_R^-$),
   b) pendant une troisième phase (III), le gradient est inversé ($G_R^+$) dans la première direction et les signaux magnétiques à résonance nucléaire produits dans une suite d'intervalles (Il à 18) d'échantillonnage sont échantillonnés sous l'effet du gradient ($G_R^+$) inversé,
   c) la séquence partielle consistant en les étapes a et b est répétée n fois,

   caractérisée en ce que, même pendant la troisième phase (III) entre les intervalles (11 à 18) d'échantillonnage, des impulsions (RF9 à RF16) haute fréquence sont envoyées en un faisceau et en ce que, même lors de la première phase, des signaux à résonance nucléaire sont échantillonnés pendant des intervalles (19 à 116) d'échantillonnage.

2. Séquence d'impulsions suivant la revendication 1, caractérisée en ce que, lors d'une deuxième phase (II)se trouvant entre la première phase (I) et la troisième phase (III) et lors d'une quatrième phase (IV) se trouvant après la troisième phase (III), un gradient ($G_{P12}$, $G_{P15}$) de codage de phases est établi dans une deuxième direction perpendiculaire à la première direction, ces gradients ($G_{P12}$, $G_{P15}$) de codage de phases ayant d'une séquence partielle à une autre séquence partielle une surface amplitude-temps qui varie.

3. Séquence d'impulsions suivant la revendication 2, caractérisée en ce que, pendant la deuxième phase (II) et pendant la quatrième phase (IV), il est établi de plus un gradient ($G_{P2}$) de codage de phases dans une troisième direction perpendiculaire à la première et à la deuxième direction, ce gradient de codage de phases ayant une surface amplitude-temps qui varie d'une séquence partielle à une autre séquence partielle.

4. Séquence d'impulsions suivant l'une des revendications 1 à 3, caractérisée en ce que, pendant la première phase (I) et/ou la troisième phase (III), il est établi un gradient ($G_{P11}$) de codage de phases dans une deuxième direction perpendiculaire à la première direction.

5. Séquence d'impulsions suivant la revendication 4, caractérisée en ce que le gradient ($G_{P11}$) de codage de phases reste établi pendant la phase associée.

6. Séquence d'impulsions suivant la revendication 4, caractérisée en ce que le gradient ($G_{P11}$) de codage de phases est constitué d'impulsions individuelles entre les intervalles (il à 116) de lecture.

7. Séquence d'impulsions suivant l'une des revendications 1 à 6, caractérisée en ce que les signaux à résonance nucléaire échantillonnés sont écrits suivant leur codage de phases dans un espace de dimension k, chacun dans une ligne de matrice de données grossières, la matrice de données grossières étant subdivisée en une pluralité de segments (Sg1 à Sgm) comportant chacun n lignes s'y rapportant, le nombre des segments (Sg1 à Sgm) correspondant au nombre de signaux (Sg1 à Sg16) à résonance nucléaire codée en phases différemment suivant la séquence partielle, et en ce qu'un codage de phases des signaux à résonance nucléaire est effectué à la phase (III) et éventuellement à la phase (IV), de telle manière que l'association des signaux (Sg1 à Sg16) à résonance nucléaire suivant à un segment (Sg1 à Sgm) en est déterminée, et en ce qu'un codage de phases est effectué aux phases I à IV de telle manière que l'association des signaux (Sg1 à Sg16) à résonance nucléaire aux lignes individuelles des segments (Sg1 à Sgm) associées en est déterminée.

8. Séquence d'impulsions suivant la revendication7, caractérisée en ce que le rangement des lignes dans la matrice de données grossières s'effectue de telle manière que les différences d'amplitude des signaux à résonance nucléaire de lignes voisines de la matrice de données grossières sont aussi petites que possible.

9. Séquence d'impulsions suivant l'une des revendications 1 à 8, caractérisée en ce que les impulsions (RF1 à RF16) à haute fréquence sont modulées en phase de telle manière que le spectre d'excitation du train d'impulsions est élargi.

10. Séquence d'impulsions suivant l'une des revendications 1 à 9, caractérisée en ce que les impulsions (RFI à RF16) haute fréquence ont pendant la première phase (I), et éventuellement pendant la troisième phase (III), une amplitude qui varie d'une impulsion haute fréquence à une autre impulsion haute fréquence.

11. Séquence d'impulsions suivant l'une des revendications 1 à 10, caractérisé en ce que les impulsions haute fréquence subissent une rotation de phase lors de phases successives.

12. Séquence d'impulsions suivant l'une des revendications 1 à 11, caractérisée en ce le codage de phase du spin nucléaire est remis à l'état initial après chaque phase (I, III) de lecture.

13. Séquence d'impulsions suivant l'une des revendications 1 à 12, caractérisée en ce que, en préparant l'aimantation longitudinale avant au moins une séquence partielle, il est provoqué un changement du contraste de l'image.

14. Séquence d'impulsions suivant l'une des revendications 1 à 13, caractérisée en ce que, en faisant varier le laps de temps entre l'excitation et les périodes de lecture, parmi les séquences partielles, les durées d'écho réelles varient de manière continue d'une ligne d'un espace de dimension k à une autre ligne d'un espace de dimension k.

FIG 1

FIG 2

FIG 3

FIG 4

FIG 5

EP 0 753 158 B1

RF | RF 1 2 3 4 5 6 7 8    9 10 11 12 13 14 15 16

I 9 10 11 12 13 14 15 16    1 2 3 4 5 6 7 8    FIG 6

$G_{P1}$    $G_{P11}$    $G_{P12}$    $G_{P15}$

FIG 7

$G_R$

FIG 8

$G_{P2}$

I    II    III    IV

n ×

FIG 9

13

FIG 10

FIG 11

FIG 12

FIG 13

FIG 14

FIG 15

FIG 16

FIG 17

FIG 18

| | |
|---|---|
| 1. Echo | ⊢ Sg1 |
| 2. Echo | |
| 3. Echo | |
| 4. Echo | |
| 5. Echo | |
| 6. Echo | |
| 7. Echo | |
| 8. Echo | ⊢ Sgm |

**FIG 19**

| | |
|---|---|
| 1. Echo | ⊢ Sg1 |
| 9. Echo | |
| 2. Echo | |
| 10. Echo | |
| 3. Echo | |
| 11. Echo | |
| 4. Echo | |
| 12. Echo | |
| 5. Echo | |
| 13. Echo | |
| 6. Echo | |
| 14. Echo | |
| 7. Echo | |
| 15. Echo | |
| 8. Echo | |
| 16. Echo | ⊢ Sg16 |

**FIG 20**

FIG 21

FIG 22